# EUROPEAN PATENT APPLICATION

(11) **EP 2 296 189 A1**
(43) Date of publication of application: **16.03.2011**
(21) Application number: 09758346.2
(22) Date of filing: 03.06.2009
(51) Int. Cl.: H01L 31/04, H01L 31/042

(54) **SOLAR CELL MODULE**

(30) Priority: 04.06.2008 JP 2008147025
(71) Applicant: Sharp Kabushiki Kaisha, Osaka-shi, Osaka 545-8522 (JP)
(72) Inventor: SHIMIZU, Akira, Osaka-shi, Osaka 545-8522 (JP)
(74) Representative: Müller - Hoffmann & Partner
(86) International application number: PCT/JP2009/060149
(87) International publication number: WO 2009/148079

(57) **Abstract**

In a solar cell module in which each lead wire (62, 63) is disposed on a back face electrode film of a solar cell string (56) with one end thereof connected to an electrode lead-out portion (60, 61) provided at an end of the solar cell string (56) and the other end of the lead wire (62, 63) is bent so as to stand up from the face of the back face electrode film to form an output lead portion (62a, 62b), in the output lead portion (62a, 62b), only one side of a tip-side portion of the lead wire including a bent portion (66a, 66b) is coated with an insulating film (59).

## Description

### Technical Field

The present invention relates to a solar cell module characterized by a structure for drawing an output lead wire drawn from a back face of a solar cell string.

### Background Art

Solar power generation systems for generating solar power in which a plurality of solar cell strings are placed in a matrix on the roof of buildings or the like are beginning to come into wide use. In such a solar cell power generation system, each solar cell module is provided with a terminal box for enabling an electrical connection with another solar cell module placed adjacent to the solar cell module.

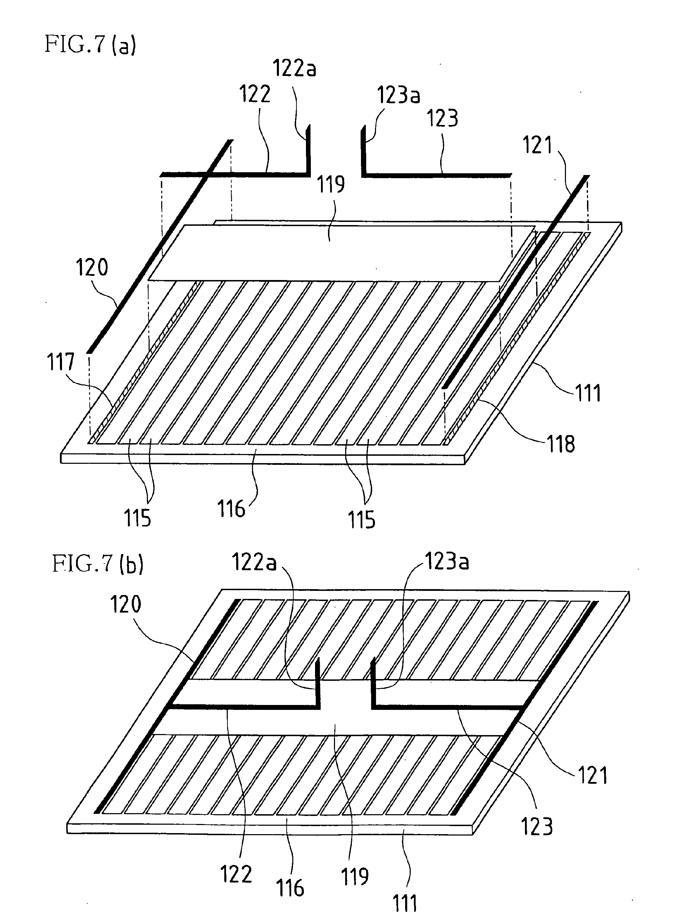

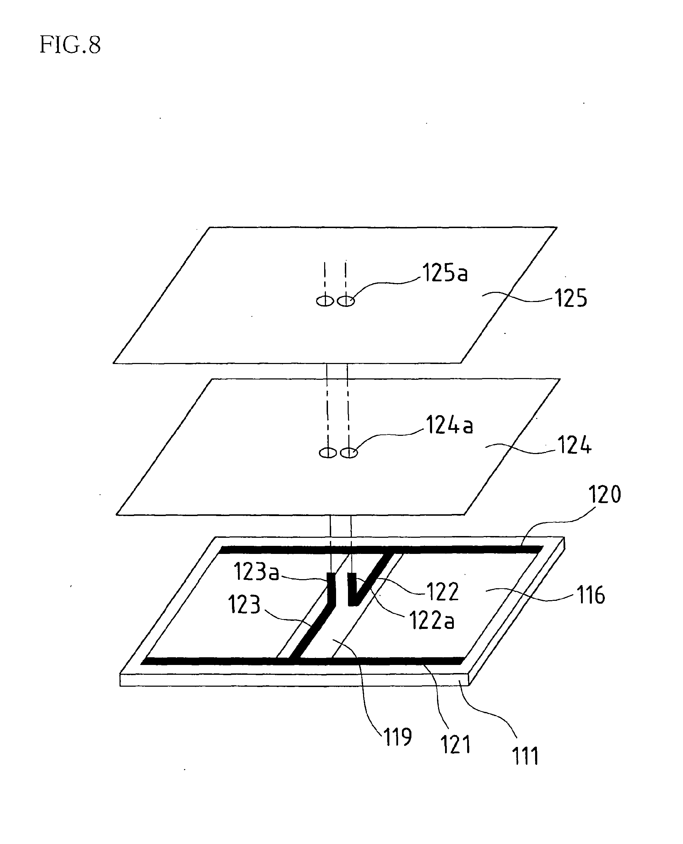

An example of a configuration of a solar cell string that constitutes a conventional solar cell module is shown in FIGS. 7(a), 7(b) and 8, with FIGS. 7(a) and 7(b) being explanatory diagrams showing two scenes of a manufacturing process thereof, and FIG. 8 being an explanatory diagram showing a step of laminating and sealing the solar cell string. The example of the configuration of the solar cell string shown in FIGS. 7 and 8 is also disclosed in Patent Document 1.

Solar cells 115 are each formed by laminating, although not shown in the drawings, a transparent electrode film made of a transparent conductive film, a photoelectric conversion layer and a back face electrode film in this order on a light-transmitting insulating substrate 111.

Each solar cell 115 thus configured has, as shown in FIG. 7(a), a strip shape with a length extending substantially across the entire width of the light-transmitting insulating substrate 111. A solar cell string 116 in which a plurality of solar cells 115 are connected in series is configured by connecting the transparent electrode film of one of each two adjacent solar cells 115 and the back face electrode film of the other solar cell to each other.

On an end of the transparent electrode film of the solar cell 115 located at one end of the solar cell string 116, a P-type electrode terminal portion 117 having a linear shape with substantially the same length as the solar cell 115 is formed, and, on an end of the back face electrode film of the solar cell 115 located at the other end of the solar cell string 116, an N-type electrode terminal portion 118 having a linear shape with substantially the same length as the solar cell 115 is formed. The P-type electrode terminal portion 117 and the N-type electrode terminal portion 118 serve as electrode lead-out portions.

An insulating sheet 119 is placed on the solar cell string 116 so as to extend between a center area of the P-type electrode terminal portion 117 and a center area of the N-type electrode terminal portion 118. The insulating sheet 119 is placed such that it does not overlap the P-type electrode terminal portion 117 and the N-type electrode terminal portion 118. The insulating sheet 119 is preferably a film compatible to a sealant, and in particular, it is optimal to use a PET film, a fluorocarbon resin film or the like. In order to ensure the adhesion of the insulating sheet, a resin adhesive sheet may be placed between the insulating sheet 119 and the solar cells 115 or between the insulating sheet 119 and a lead wire 112 or 113, or these may be bonded in advance with an adhesive or the like.

On the other hand, a positive electrode current collecting portion 120 called "bus bar" and made of a copper foil having the same shape and size as the P-type electrode terminal portion 117 is electrically and mechanically bonded to the entire face of the P-type electrode terminal portion 117. Likewise, a negative electrode current collecting portion 121 having the same shape and size as the N-type electrode terminal portion 118 is electrically and mechanically bonded to the entire face of the N-type electrode terminal portion 118. As a means of bonding these, soldering or a conductive paste can be used, for example.

A positive electrode lead wire 122 and a negative electrode lead wire 123 that are made of flat cables are disposed in line (or parallel, i.e., disposed offset in the width direction) on the insulating film 119, with their tips facing each other.

One end of the positive electrode lead wire 122 is connected to a center position of the positive electrode current collecting portion 120. The other end of the positive electrode lead wire 122 is located in a substantially center area of the solar cell string 116, and is bent so as to stand up from the face of the solar -cell string 116 (for example, vertically with respect to the face) to serve as an output lead portion 122a. Likewise, one end of the negative electrode lead wire 123 is connected to a center position of the negative electrode current collecting portion 121. The other end of the negative electrode lead wire 123 is located in a substantially center area of the solar cell string 116, and is bent so as to stand up from the face of the solar cell string 116 (for example, vertically with respect to the face) to serve as an output lead portion 123a.

Although the positive electrode lead wire 122 and the negative electrode lead wire 123 extend across a plurality of solar cells 115, the insulating sheet 119 is present between the lead wires and the solar cells 115, and therefore the solar cells 115 will not be short-circuited. It is desirable that the width of the insulating sheet 119 is sufficiently larger than the width of the positive electrode lead wire 122 and the negative electrode lead wire 123, and the insulating sheet 119 is disposed in the form of a belt-like sheet extending from the positive electrode current collecting portion 120 to the negative electrode current collecting portion 121.

In this state, as shown in FIG. 8, a sealing film 124 and a back film 125 serving as a back face protection material for weather resistance and high insulation are laminated and sealed on the entire face of the solar cell string 116, with the output lead portions 122a and 123a of the positive electrode lead wire 122 and the negative electrode lead wire 123 passing through through holes 124a and through holes 125a. The sealing film 124 is preferably a thermoplastic polymer film, and in particular, it is optimal to use a film made of EVA (ethylene vinyl acetate resin) or PVB (polyvinyl butyral resin). The back film 125 is preferably, in order to ensure moistureproofproperty, a film including a moistureproof layer such as a three-layer structure film of PET/Al/PET (PET: polyethylene terephthalate) or a three-layer structure film of PVF/Al/PVF (PVF: polyvinyl fluoride resin film).

In the solar cell string 116 thus configured, a terminal box (not shown) is attached and electrically connected to the output lead portions 122a and 123a of the positive electrode lead wire 122 and the negative electrode lead wire 123 protruding upward from the through holes 125a of the back film 125.

As described above, the conventional solar cell module configuration and manufacturing method require a large number of complex tasks. Specifically, tasks of placing the insulating sheet 119 on the solar cell string 116 and disposing the positive electrode lead wire 122 and the negative electrode lead wire 123 that are made of flat cables on the insulating sheet 119 are required. In this case, in consideration of a positional offset when placing the insulating sheet 119, the width of the insulating sheet 119 needs to be sufficiently larger than the width of the positive electrode lead wire 122 and the negative electrode lead wire 123 and, in addition, a large amount of insulating sheet is needed because the insulating sheet 119 is disposed in the form of a belt-like sheet extending from the positive electrode current collecting portion 120 to the negative electrode current collecting portion 121. This inevitably leads to an increase in the cost of components and a problem in that placing the insulating sheet and disposing the positive electrode lead wire 122 and the negative electrode lead wire 123 need to be performed very carefully, which reduces manufacturing efficiency.

Under such circumstances, in order to solve the above problems, in a solar cell module disclosed in Patent Document 1, the positive electrode lead wire 122 and the negative electrode lead wire 123 are entirely coated with a highly heat-resistant insulating film. Specifically, the positive electrode lead wire 122 is entirely coated with the insulating film, except for an end that is connected to the positive electrode current collecting portion 120 and the other end that is connected to the terminal block of a terminal box, and the negative electrode lead wire 123 is entirely coated with the insulating film, except for an end that is connected to the negative electrode current collecting portion 121 and the other end that is connected to the terminal block of a terminal box. By entirely coating the lead wires with an insulating film as described above, the need for placing the insulating sheet 119 is eliminated when disposing the positive electrode lead wire 122 and the negative electrode lead wire 123 on the solar cell string 116, and the positive electrode lead wire 122 and the negative electrode lead wire 123 can be disposed directly on the solar cell string 116, as a result of which reduction in the cost of components and in the number of production steps as well as ease of arrangement (or in other words, there is no concern of short-circuiting even if a slight positional offset occurs) can be achieved due to omission of the insulating sheet 119, and consequently, manufacturing efficiency and the like can be improved.

### Prior Art Document

### Patent Document

[Patent Document 1] JP H9-326497A

### Summary of Invention

### Problems to be Solved by the Invention

However, the solar cell module of Patent Document 1 is problematic in that when, for example, bending the output lead portions 122a and 123a at their root portions in order to vertically raise the output lead portions 122a and 123a, the output lead portions 122a and 123a may lean after they are bent vertically because of increased elasticity and resilience provided by the insulating film coating the output lead portions. Accordingly, when laminating and sealing the sealing insulating film 124 and the back film 125 on the entire face of the solar cell string 116, a problem arises in that positioning of the output lead portions 122a and 123a relative to the through holes 124a of the sealing insulating film 124 and the through holes 125a of the back film 125 becomes difficult, and the laminating step takes more time.

The present invention has been conceived to solve the above problems, and it is an object of the present invention to provide a solar cell module that enables a positive electrode lead wire and a negative electrode lead wire to be disposed directly on a solar cell string so that an insulating sheet is omitted and reduction in the cost of components and in the number of production steps as well as ease of arrangement are ensured, and that facilitates positioning of an output lead portion relative to through holes of a sealing insulating film and a back film when laminating and sealing the sealing insulating film and the back film onto the entire face of the solar cell string by reducing the elasticity and resilience of an insulating film coating the output lead portion when the output lead portion is bent at its root portion so as to stand up at a predetermined angle.

### Means for Solving the Problems

In order to solve the above problems, a solar cell module according to the present invention is a solar cell module in which a solar cell string is formed with solar cells connected in series, each solar cell formed with a transparent electrode film, a photoelectric conversion layer and a back face electrode film laminated in this order on a light-transmitting insulating substrate, a coated lead wire is disposed on the back face electrode film with one end thereof connected to an electrode lead-out portion provided at an end of the solar cell string, and the other end of the coated lead wire is bent so as to stand up from a face of the back face electrode film to form an output lead portion, wherein, in the output lead portion, a tip-side portion of the lead wire including the bent portion is provided with a single-sided insulation coating. More specifically, the single-sided insulation coating is provided on a side of the lead wire that faces the back face electrode film.

Also, a portion of the lead wire that passes through a through hole of a back film laminated on the solar cell is provided with the single-sided insulation coating, and a portion extending from the portion provided with the single-sided insulation coating to a portion that comes into contact with a terminal block of a terminal box that is placed on the back film is not provided with an insulation coating.

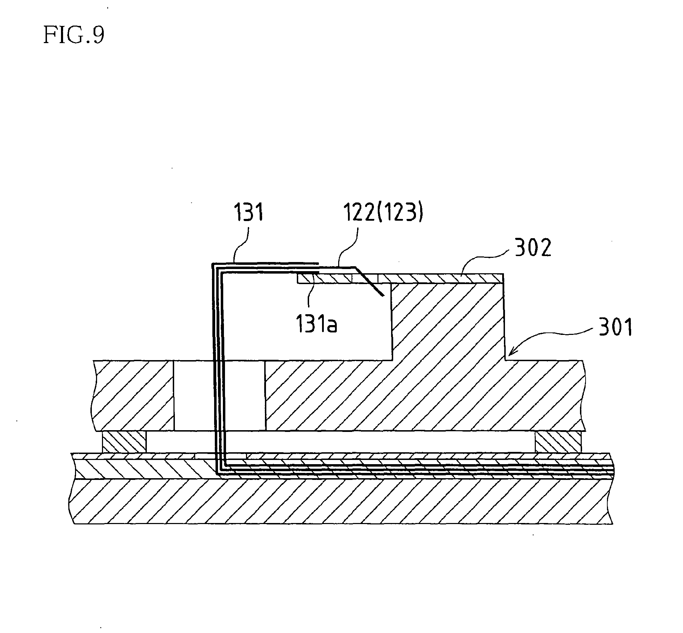

As described above, according to the present invention, when a lead wire is disposed on a solar cell string and an output lead portion is bent at its root portion so as to stand up at a predetermined angle (vertically, for example), because an insulating film is provided only on one side of the bent portion of the lead wire, the elasticity and resilience provided by the insulating film are reduced, and it is therefore possible to easily bend the output lead portion at a predetermined angle. Accordingly, positioning of the output lead portion relative to a through hole of a back film can be facilitated when laminating and sealing the back film on the entire face of the solar cell string, and thus the time required for the laminating step can be shortened. In addition, a portion of the lead wire that passes through the through hole of the back film is provided with the single-sided insulation coating, and a portion of the lead wire extends from the portion provided with the single-sided insulation coating to a portion that comes into contact with a terminal block of a terminal box that is placed on the back film is not provided with an insulation coating, and therefore even if a positional offset or difference in length occurs in the lead wire when soldering the lead wire to the terminal block, a situation can be prevented in which the insulating film is jammed between the terminal block and the lead wire, causing a soldering defect. In this connection, as in Patent Document 1, in the case where the positive electrode lead wire 122 and the negative electrode lead wire 123 are entirely coated with an insulating film 131, as shown in FIG. 9, there is a possibility that when soldering the lead wire 122 or 123 to a terminal block 302 of a terminal box 301, the coated portion 131a might be jammed between the lead wire 122 or 123 and the terminal block 302, causing a soldering defect.

The single-sided insulation coating can be formed by attaching insulation tape to one side of the lead wire or by removing the coating from one side of a coated lead wire coated on both sides.

A solar cell module according to the present invention is a solar cell module in which a solar cell string is formed with solar cells connected in series, each solar cell formed with a transparent electrode film, a photoelectric conversion layer and a back face electrode film laminated in this order on a light-transmitting insulating substrate, a lead wire is disposed on the back face electrode film with one end thereof connected to an electrode lead-out portion provided at an end of the solar cell string, and the other end of the lead wire is bent so as to stand up from a face of the back face electrode film to form an output lead portion, wherein a side of the lead wire that faces the back face electrode film is provided with a single-sided coating with an insulating film.

By providing an insulating film only on one side of a lead wire, it is possible to reduce the amount of use of the insulating film to the required minimum, leading to a reduction in the cost of components. Also, the insulating film is provided on a side that faces the back face electrode film of the solar cell string, and thus arrangement and positioning of the lead wire onto the solar cell string can be facilitated.

In addition, a portion of the lead wire that extends to a portion that passes through the through hole of the back film is provided with a single-sided insulation coating, and a portion of the lead wire that extends from the portion provided with the single-sided insulation coating to a portion that comes into contact with a terminal block of a terminal box that is placed on the back film is not provided with an insulation coating. Accordingly, even if a positional offset or difference in length occurs in the lead wire when soldering the lead wire to the terminal block, a situation can be prevented in which the insulating film is jammed between the terminal block and the lead wire, causing a soldering defect. The single-sided insulation coating can be formed by attaching insulation tape to one side of the lead wire.

### Effects of the Invention

According to the present invention, when an output lead portion is bent at its root portion so as to stand up at a predetermined angle, because an insulating film is provided only on one side of the bent portion of the lead wire, the elasticity and resilience provided by the insulating film are reduced, and it is therefore possible to easily bend the output lead portion at a predetermined angle. Accordingly, positioning of the output lead portion relative to a through hole of a back film can be facilitated when laminating and sealing the back film on the entire face of the solar cell string, and thus the time required for the laminating step can be shortened. Also, the insulating film is provided only on one side of the lead wire, and it is therefore possible to reduce the amount of use of the insulating film to the required minimum, leading to a reduction in the cost of components. In addition, the insulating film is provided on a side that faces the back face electrode film of the solar cell string, and thus arrangement and positioning of the lead wire onto the solar cell string can be facilitated.

### Brief Description of Drawings

[FIGS. 1] FIGS. 1 show an example of a configuration of a solar cell string according to Embodiment 1 of the present invention, with FIGS. 1(a) and 1(b) showing two scenes of a manufacturing process thereof.
[FIG. 2] FIG. 2 is an explanatory diagram showing a step of laminating and sealing the solar cell string according to Embodiment 1 of the present invention.
[FIG. 3] FIG. 3 is a partially enlarged perspective view showing the periphery of output lead portions according to Embodiment 1 of the present invention.
[FIG. 4] FIG. 4 is a partially enlarged perspective view showing the periphery of output lead portions according to Embodiment 2 of the present invention.
[FIGS. 5] FIGS. 5 show an example of a terminal box according to the present invention, with FIG 5(a) being a cross-sectional view and FIG. 5(b) being a plan view.
[FIG. 6] FIG. 6 is a perspective view of the terminal box shown in FIGS. 5.
[FIGS. 7] FIGS. 7 show an example of a configuration of a conventional solar cell string, with FIGS. 7(a) and 7(b) showing two scenes of a manufacturing process thereof.
[FIG. 8] FIG. 8 is an explanatory diagram showing a step of laminating and sealing the conventional solar cell string.
[FIG. 9] FIG. 9 is a partially enlarged cross-sectional view showing a state in which a lead wire of a conventional solar cell string is soldered to a terminal block.

### Modes for Carrying out the Invention

Hereinafter, embodiments of the present invention will be described with reference to the drawings.

### <Description of Solar Cell String according to Embodiment 1>

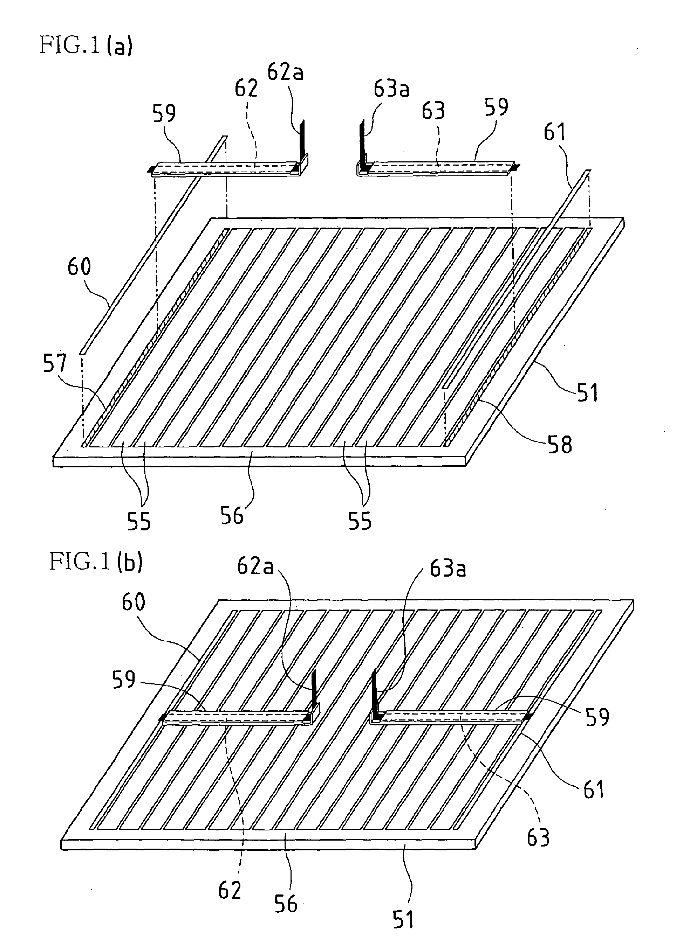

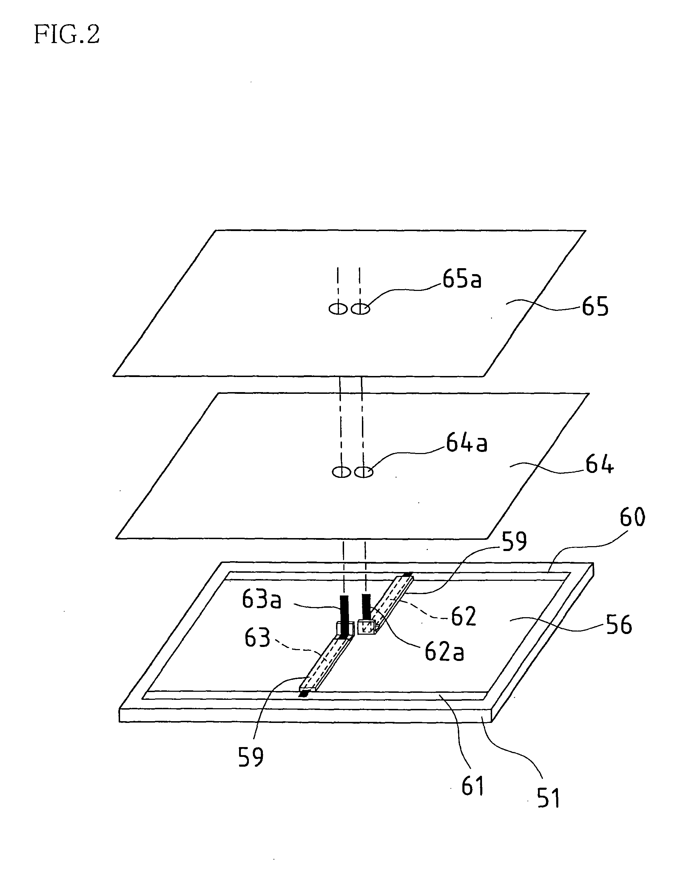

FIGS. 1(a), 1(b) and 2 show a solar cell module according to Embodiment 1, with FIGS. 1(a) and 1(b) being explanatory diagrams showing two scenes of a manufacturing process thereof, and FIG. 2 being an explanatory diagram showing a step of laminating and sealing the solar cell string.

Solar cells 55 are each formed by laminating, although not shown in the drawings, a transparent electrode film made of a transparent conductive film, a photoelectric conversion layer and a back face electrode film in this order on a light-transmitting insulating substrate 51. The light-transmitting insulating substrate can be made of glass or a heat-resistant resin such as polyimide. The transparent electrode film can be made of SnO₂, ZnO, ITO, or the like. The photoelectric conversion layer can be made of a silicon-based photoelectric conversion film such as amorphous silicon or microcrystalline silicon, or a compound-based photoelectric conversion film such as CdTe or CuInSe₂.

Each solar cell 55 thus configured has, as shown in FIG. 1(a), a strip shape with a length extending substantially across the entire width of the light-transmitting insulating substrate 51. A solar cell string 56 in which a plurality of solar cells 55 are connected in series is configured by connecting the transparent electrode film of one of each two adjacent solar cells 55 and the back face electrode film of the other solar cell to each other.

On an end of the transparent electrode film of the solar cell 55 located at one end of the solar cell string 56, a P-type electrode terminal portion 57 having a linear shape with substantially the same length as the solar cell 55 is formed, and on an end of the back face electrode film of the solar cell 55 located at the other end of the solar cell string 56, an N-type electrode terminal portion 58 having a linear shape with substantially the same length as the solar cell 55 is formed. The P-type electrode terminal portion 57 and the N-type electrode terminal portion 58 serve as electrode lead-out portions. By forming the solar cells 55 and the electrode terminal portions 57 and 58 to have the same length as described above, a current flowing through the solar cells 55 of the solar cell string 56 in series can be extracted uniformly without local concentration of the current, and it is therefore possible to suppress the occurrence of series resistance losses.

A positive electrode current collecting portion 60 called "bus bar" and made of a copper foil having substantially the same shape and size as the P-type electrode terminal portion 57 is electrically and mechanically bonded to the entire face of the P-type electrode terminal portion 57, and a negative electrode current collecting portion 61 having the same shape and size as the N-type electrode terminal portion 58 is electrically and mechanically bonded to the entire face of the N-type electrode terminal portion 58. As a means of bonding these, soldering or a conductive paste can be used, for example.

In the configuration described above, a positive electrode lead wire 62 and a negative electrode lead wire 63 that are made of flat cables and coated with an insulation coating (hereinafter referred to as an "insulating film") 59 are disposed in line (or parallel, i.e., disposed offset in the width direction), with their tips facing each other.

One end of the positive electrode lead wire 62 is connected to a center position of the positive electrode current collecting portion 60, and the other end is located in a substantially center area of the solar cell string 56 and is bent at a predetermined angle (vertically in Embodiment 1) with respect to the face of the solar cell string 56 to serve as an output lead portion 62a. Likewise, one end of the negative electrode lead wire 63 is connected to a center position of the negative electrode current collecting portion 61, and the other end is located in a substantially center area of the solar cell string 56 and is bent at a predetermined angle (vertically in Embodiment 1) with respect to the face of the solar cell string 56 to serve as an output lead portion 63a. The bending angle (predetermined angle) of the output lead portions 62a and 63a is not necessarily limited to the vertical direction because it is related to the shape of the terminal box, but the present embodiment 1 and the next embodiment 2 will be described in the context of the output lead portions being bent vertically.

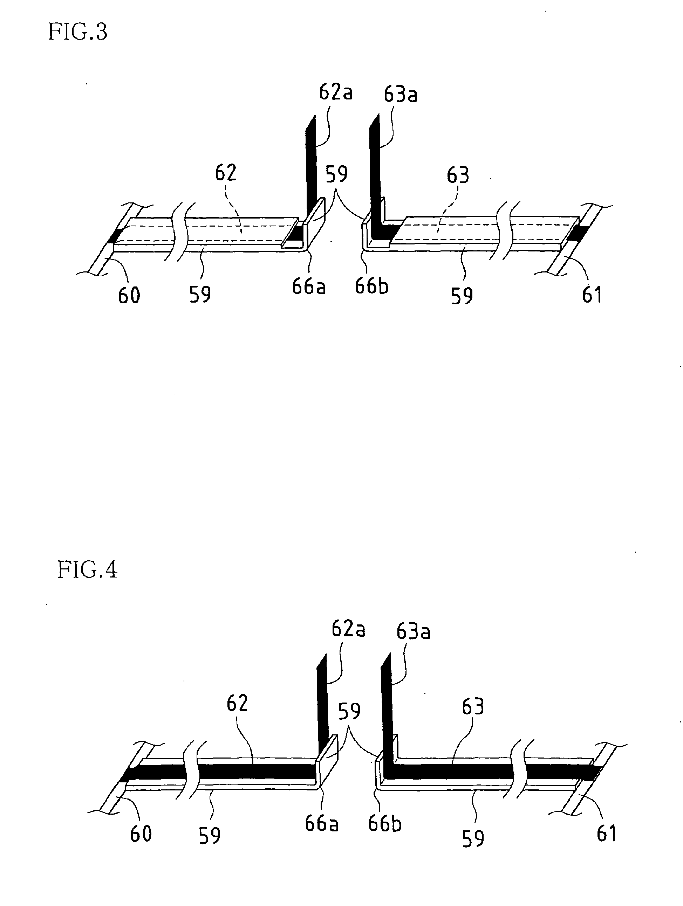

FIG. 3 is a partially enlarged perspective view showing the periphery of the output lead portions 62a and 63a.

In Embodiment 1, the output lead portions 62a and 63a each include a tip-side portion of the lead wire including a bent portion 66a, 66b that is coated single-sidedly with the insulating film 59. More specifically, the insulating film 59 coating such portions is provided on a side of the lead wires 62 and 63 that faces the back face electrode film of the solar cell string 56. In other words, when the output lead portions 62a and 63a are bent at the root portions thereof in order to vertically raise the output lead portions 62a and 63a, they can be bent vertically with ease because, in those portions, the insulating film 59 is provided only on one side of each lead wire 62, 63, and thus the elasticity and resilience provided by the insulating film 59 are low.

The positive electrode lead wire 62 and the negative electrode lead wire 63 are made of the same material (namely, a copper foil) as that of the positive electrode current collecting portion 60 and the negative electrode current collecting portion 61, and as a means of bonding the lead wires and the current collecting portions, soldering or spot welding can be used, for example. Although the positive electrode lead wire 62 and the negative electrode lead wire 63 extend across a plurality of solar cells 55, because the lead wires 62 and 63 are entirely coated with the insulating film 59, the solar cells 55 will not be short-circuited.

In this state, as shown in FIG. 2, a sealing insulating film 64 and a back film 65 serving as a back face protection material for weather resistance and high insulation are laminated and sealed on the entire face of the solar cell string 56, with the output lead portions 62a and 63a of the positive electrode lead wire 62 and the negative electrode lead wire 63 passing through through holes 64a and through holes 65a. The sealing insulating film 64 can be a film that has good adhesion properties to the back film 65, the insulating film 59 and the solar cells 55 and superior long-term weather resistance, such as PVB or silicon, but in particular, it is optimal to use a film made of EVA (ethylene vinyl acetate resin) because it has shown satisfactory performance as a film for solar cells. In particular, by selecting films having good adhesion to each other as the sealing insulating film 64 and the insulating film 59, the water resistance of the solar cell string can be improved. The back film 65 is preferably a three-layer structure film including a moistureproof layer (an Al layer in this case) such as a PET/Al/PET film (PET: polyethylene terephthalate). As for the thicknesses of these films, for example, when the insulating film 59 has a thickness of 50 µm and the sealing insulating film 124 has a thickness of 600 µm, the back film 65 has a thickness of 100 um.

In the solar cell string 56 thus configured, a terminal box 10, which will be described later, is attached and electrically connected to the output lead portions 62a and 63a of the positive electrode lead wire 62 and the negative electrode lead wire 63 protruding upward from the through holes 65a of the back film 65.

In Embodiment 1, a portion of each lead wire 62, 63 that passes through the through hole 65a of the back film 65 is coated on one side with the insulating film 59, but a portion of each lead wire 62, 63 that extends from the one-side coated portion to a portion that comes into contact with a terminal block 20 of the terminal box 10 placed on the back film 65 is not provided with the insulation coating, and therefore even if a positional offset or difference in length occurs in the output lead portion 62a, 63a when soldering the output lead portion 62a, 63a to the terminal block 20, a situation can be prevented in which the insulating film 59 is jammed between the terminal block 20 and the output lead portion 62a, 63a, causing a soldering defect.

The electrode arrangement in the solar cell string 56 is merely exemplary, and the arrangement is not limited thereto. For example, the positive electrode lead wire 62 and the negative electrode lead wire 63 may be disposed at a position toward one of the ends of the solar cell string 56, rather than the center area of the solar cell string 56, and the lead wires may not need to be drawn to the center area. In other words, the positive electrode lead wire 62 and the negative electrode lead wire 63 may be disposed such that the output lead portions 62a and 63a protrude upward from near the positive electrode current collecting portion 60 and the negative electrode current collecting portion 61.

### <Description of Solar Cell String according to Embodiment 2>

According to Embodiment 1 described above, a portion of each lead wire 62, 63 that extends from the current collecting portion 60, 61 to before the bent portion 66a, 66b is entirely coated with the insulating film 59, and the tip-side portion of the output lead portion 62a, 63a including the bent portion 66a, 66b is coated single-sidedly with the insulating film 59. In Embodiment 2, as shown in FIG. 4, the entire portion extending from the current collecting portion 60, 61 to the tip-side portion of the output lead portion 62a, 63a including the bent portion 66 is coated single-sidedly with the insulating film 59. More specifically, the insulating film 59 is provided on a side of each lead wire 62, 63 that faces the back face electrode film of the solar cell string 56. In other words, when the output lead portions 62a and 63a are bent at the root portions thereof in order to vertically raise the output lead portions 62a and 63a, they can be bent vertically with ease because, in those portions, the insulating film 59 is provided only on one side of each lead wire 62, 63, and thus elasticity and resilience provided by the insulating film 59 are low. In addition, by providing the insulating film 59 only on one side, extending across substantially the entire length of each lead wire 62, 63, the amount of use of the insulating film can be reduced to the required minimum, leading to a reduction in the cost of components.

### <Description of Terminal Box>

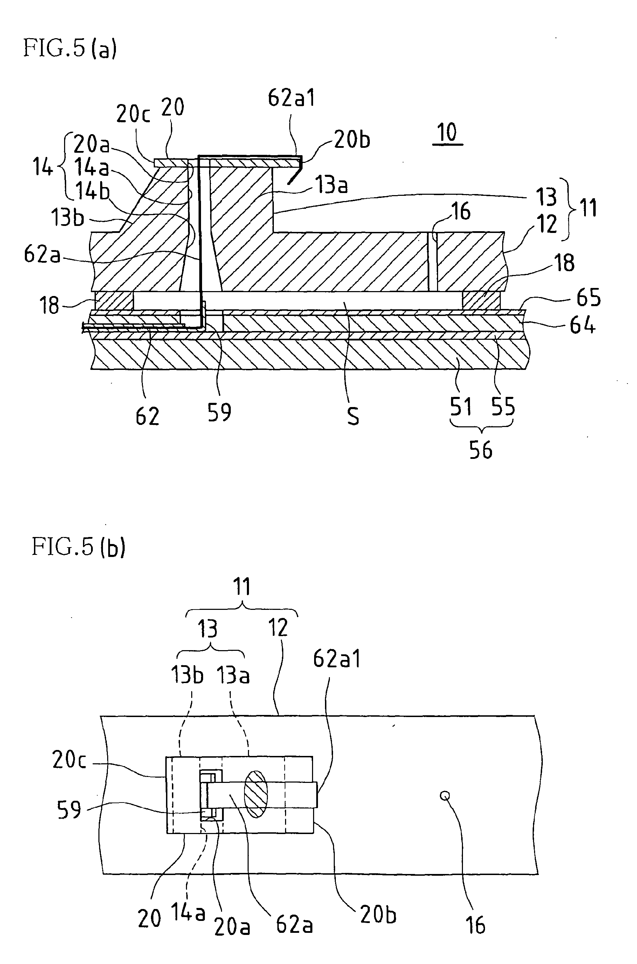

FIGS. 5 show an example of a configuration of a terminal box according to the present embodiment, with FIG. 5(a) being a schematic cross-sectional view and FIG. 5(b) being a plan view. FIG. 5 is a perspective view of the terminal box from which a terminal block portion has been separated. The terminal box is attached to each of the upstanding terminal portion 62a of the positive electrode current collecting portion 20 and the upstanding terminal portion 63a of the negative electrode current collecting portion 21, but the attachment structure is the same, and thus the present embodiment will be described in the context of the terminal box being attached to the upstanding terminal portion 62a of the positive electrode current collecting portion 20.

A terminal box 10 according to the present embodiment includes a box case 11 that is placed on and fixed to the back film 65 of the solar cell string 56 in order to electrically connect the output lead portion 62a drawn from the back face (back film 65) of the solar cell string 56 and a terminal block 20 that is formed on the box case 11. The box case 11 includes a case main body 12 that is placed on and fixed to the back film 65 of the solar cell string 56 and a terminal block fixing portion 13 for placing and fixing the terminal block 20 on and to the top of the case main body 12.

In the present embodiment, as shown in FIG. 5(b), the box case 11 is formed to have a rectangular parallelepiped shape that is longer in the sideways direction in the diagram and shorter in the width direction, and the terminal block fixing portion 13 is formed to have a substantially cubic shape as a whole.

In such a configuration of the box case 11, in the present embodiment, an opening 14 (14a, 14b, 20a) for passing the output lead portion 62a to a position above the terminal block 20 is formed continuously from the bottom face of the case main body 11 to the top face of the terminal block 20.

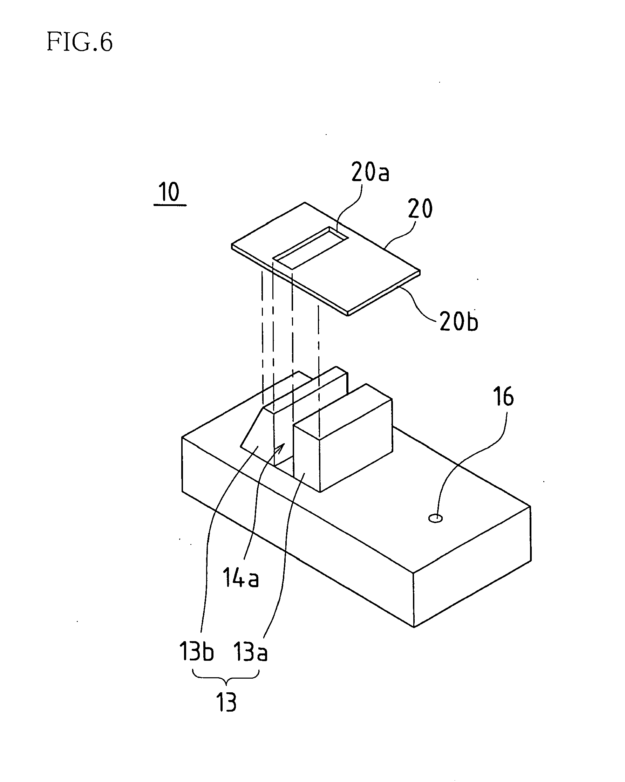

In the present embodiment, as shown in FIG. 6, the opening 14a formed in the terminal block fixing portion 13 is formed by a pair of terminal block fixing pieces 13a and 13b that are provided upright with a predetermined spacing therebetween in the lateral direction of the case main body 11, and the space between the terminal block fixing pieces 13a and 13b serves as the opening 14a for passing the output lead portion 62a. In other words, the opening 14a formed in the terminal block fixing portion 13 has a groove-like structure in which two sides are open, rather than a cylindrical hole. Accordingly, when resin-sealing the terminal box 10 by potting after the output lead portion 62a and an external output line (not shown) for connecting another solar cell module disposed adjacent thereto have been connected to the terminal box 10, the potting material can easily flow from the opening 14a into the opening 14b provided in the case main body 11 (and to the back film 65 of the solar cell string 56), and it is thereby possible to reliably resin-seal the periphery of the output lead portion 62a drawn from the solar cell string 56.

The opening 20a of the terminal block 20 is also formed to have a rectangular shape that is longer in the width direction so as to conform to the above-described shape of the opening 14a.

Also, in the present embodiment, the opening 14b formed in the case main body 11 is formed to have a quadrilateral shape as viewed from above, and each of inner wall faces defining the opening 14b is formed to have a tapered shape that gradually becomes wider from the side communicating with the terminal block fixing portion 13 (in other words, the lower edge of the opening 14a) toward the bottom face of the case main body 11. By forming each of the inner wall faces to have such a tapered shape, the opening diameter of the lower end of the opening 14b for passing the output lead portion 62a becomes large, and it is therefore possible to prevent drawbacks such as the output lead portion 62a coming into contact with the edge of the opening 14b and thus being bent when the terminal box 1 is placed from above.

Also, in the present embodiment, the terminal block 20 is formed to have a quadrilateral shape so as to conform to the shape of the top face of the terminal block fixing portion 13, but one edge 20b is provided so as to protrude from the terminal block fixing portion 13 so that a tip 62al of the output lead portion 62a can be bent and latched on. In other words, in the present embodiment, the tip 62al of the output lead portion 62a can be latched on and fixed to the terminal block 20 by bending the output lead portion 62a protruding above from the opening 20a of the terminal block 20 toward one edge of the terminal block 20 (toward the right in FIG. 1) so as to press it against the edge of the opening 20a and bending the tip of the bent output lead portion downward and backward so as to press it against the edge 20b of the terminal block 20. That is to say, by bending the output lead portion 62a only twice at two bending points, namely, the edge of the opening 20a of the terminal block 20 and one edge 20b of the terminal block 20, the tip 62al of the output lead portion 62a can be reliably latched on and fixed to the terminal block 20. Consequently, the next step of soldering the bent portions of the output lead portion 62a to the terminal block 20 can be performed in a stable manner, and it is therefore possible to achieve a terminal box attachment structure that is sufficiently in compliance with the IEC standards.

In FIGS. 5, the output lead portion 62a protruding upward from the opening 20a of the terminal block 20 is bent toward the right side of the terminal block 20 so as to press it against the edge of the opening 20a, and the tip of the bent output lead portion is bent downward and backward so as to press it against the right-side edge 20b of the terminal block 20, but it is also possible to employ a configuration that is opposite thereto: the output lead portion 62a protruding upward from the opening 20a of the terminal block 20 is bent toward the left side of the terminal block 20 so as to press it against the edge of the opening 20a, and the tip of the bent output lead portion is bent downward and backward so as to press it against a left-side edge 20c of the terminal block 20. In the case of bending the output lead portion 62a in this direction, the face of the output lead portion 62a that is not coated with the insulating film 59 comes into contact with the terminal block 20, and therefore even if a positional offset or difference in length occurs in the output lead portion 62a of the lead wire 62 when soldering the lead wire 62 to the terminal block 20, a situation can be prevented in which the insulating film 59 is jammed between the terminal block 20 and the output lead portion 62a, causing a soldering defect.

Also, in the present embodiment, an air vent hole 16 extending from the bottom face to the top face of the case main body 11 may be provided at an appropriate location of the case main body 11. It should be noted, however, that the air vent 16 is provided at a position sufficiently away from the terminal block fixing portion 13. In order to attach the terminal box 10 onto the back film 65 of the solar cell string 56, an adhesive silicone resin 18 is applied to the bottom face of the case main body 12 of the terminal box 10 at the periphery thereof (it may be applied around the entire periphery or may be applied to four corners, for example). Thus, when the terminal box 10 is adhesively fixed onto the back film 65 of the solar cell string 56, a gap S corresponding to the thickness of the silicon resin 18 is created between the bottom face of the case main body 12 and the back film 65 of the solar cell string 56. Accordingly, by providing the air vent hole 16, the air present within the opening 14 and in the gap S between the back film 65 of the solar cell string 56 and the bottom face of the case main body 12 of the terminal box 10 can escape to the outside through the air vent hole 16 when the potting material flows into the opening 14, and it is therefore possible to reliably fill the potting material into the opening 14 (more specifically, to the back film 65 of the solar cell string 56 within the opening 14, and to the gap S between the back film 65 of the solar cell string 56 and the bottom face of the case main body 12 of the terminal box 10), as a result of which resin-sealing without creating air gap can be performed.

Although not shown in the drawings, as the method of fixing an external output line fixed onto the terminal block 20, a method can be used in which a connection end of the external output line is swaged directly to the other end of the terminal block 20 by means of a rivet or the like. As described above, a solar cell module is produced by attaching the terminal box 10 onto the back film 65 of the solar cell string 56, electrically connecting the output lead portion 62a to the terminal block 20, and electrically connecting an external output line to the terminal block 20.

The present invention may be embodied in various other forms without departing from the gist or essential characteristics thereof. Therefore, the embodiments given above are to be considered in all respects as illustrative and not limiting. The scope of the invention is indicated by the appended claims rather than by the foregoing description, and all modifications or changes that come within the meaning and range of equivalency of the claims are intended to be embraced therein.

This application claims priority on Japanese Patent Application No. 2008-147025 filed in Japan on June 4, 2008, the entire content of which is incorporated herein by reference. Furthermore, the entire content of references cited in the present specification is herein specifically incorporated by reference.

### Industrial Applicability

According to the present invention, positioning of an output lead portion relative to a through hole of a back film can be facilitated when laminating and sealing the back film on the entire face of a solar cell string, and thus the time required for the laminating step can be shortened. Also, an insulating film is provided only on one side of the lead wire, and it is therefore possible to reduce the amount of use of the insulating film to the required minimum, leading to a reduction in the cost of components. In addition, the insulating film is provided on a side that faces the back face electrode film of the solar cell string, and thus arrangement and positioning of the lead wire onto the solar cell string can be facilitated. Therefore, the present invention is useful.

### Description of Reference Numerals

- 10: Terminal Box
- 11: Box Case
- 12: Case Main Body
- 13: Terminal Block Fixing Portion
- 13a, 13b: Terminal Block Fixing Piece
- 14 (14a, 14b, 20a): Opening
- 16: Air Vent Hole
- 20: Terminal Block
- 20b: Right-Side Edge
- 20c: Left-Side Edge
- 51: Light-Transmitting Insulating Substrate
- 55: Solar Cell
- 56: Solar Cell String (Thin Film Solar Cell String)
- 57: P-Type Electrode Terminal Portion
- 58: N-Type Electrode Terminal Portion
- 59: Insulation Coating (Insulating Film)
- 60: Positive Electrode Current Collecting Portion
- 61: Negative Electrode Current Collecting Portion
- 62: Positive Electrode Lead Wire
- 63: Negative Electrode Lead Wire
- 62a, 63a: Upstanding Terminal Portion
- 62a1: Tip
- 64: Sealing Insulating Film
- 65: Back Film
- 64a, 65a: Through Hole

## Claims

1. A solar cell module in which a solar cell string is formed with solar cells connected in series, each solar cell formed with a transparent electrode film, a photoelectric conversion layer and a back face electrode film laminated in this order on a light-transmitting insulating substrate, a coated lead wire is disposed on the back face electrode film with one end thereof connected to an electrode lead-out portion provided at an end of the solar cell string, and the other end of the coated lead wire is bent so as to stand up from a face of the back face electrode film to form an output lead portion,
wherein, in the output lead portion, a tip-side portion of the lead wire including the bent portion is provided with a single-sided insulation coating.

2. The solar cell module according to claim 1,
wherein the single-sided insulation coating is provided on a side of the lead wire that faces the back face electrode film.

3. The solar cell module according to claim 2,
wherein a portion of the lead wire that passes through a through hole of a back film laminated on the solar cell is provided with the single-sided insulation coating, and a portion of the lead that extends from the portion provided with the single-sided insulation coating to a portion that comes into contact with a terminal block of a terminal box that is placed on the back film is not provided with an insulation coating.

4. The solar cell module according to any one of claims 1 to 3,
wherein the single-sided insulation coating is formed by attaching insulation tape to one side of the lead wire or by removing the coating from one side of a coated lead wire coated on both sides.

5. A solar cell module in which a solar cell string is formed with solar cells connected in series, each solar cell formed with a transparent electrode film, a photoelectric conversion layer and a back face electrode film laminated in this order on a light-transmitting insulating substrate, a lead wire is disposed on the back face electrode film with one end thereof connected to an electrode lead-out portion provided at an end of the solar cell string, and the other end of the lead wire is bent so as to stand up from a face of the back face electrode film to form an output lead portion,
wherein a side of the lead wire that faces the back face electrode film is provided with a single-sided coating with an insulating film.

6. The solar cell module according to claim 5,
wherein a portion of the lead wire that passes through a through hole of a back film laminated on the solar cell is provided with a single-side insulation coating, and a portion of the lead that extends from the portion provided with the single-sided coating to a portion that comes into contact with a terminal block of a terminal box that is placed on the back film is not provided with an insulation coating.

7. The solar cell module according to claim 5 or 6,
wherein the single-sided insulation coating is formed by attaching insulation tape to one side of the lead wire.
